# EUROPÄISCHE PATENTSCHRIFT

(11) **EP 1 829 128 B1**
(45) Veröffentlichungstag und Bekanntmachung des Hinweises auf die Patenterteilung: **04.08.2010**
(21) Anmeldenummer: 05792058.9
(22) Anmeldetag: 05.10.2005
(51) Int. Cl.: H01L 41/12

(54) **VORRICHTUNG MIT FORMGEDÄCHTNISELEMENT**
DEVICE COMPRISING A SHAPE MEMORY ELEMENT
DISPOSITIF COMPRENANT UN ELEMENT A MEMOIRE DE FORME

(30) Priorität: 16.12.2004 DE 102004060532
(43) Veröffentlichungstag der Anmeldung: 05.09.2007
(73) Patentinhaber: ROBERT BOSCH GMBH, 70442 Stuttgart (DE)
(72) Erfinder: HOANG, Anh-Tuan, 71732 Tamm (DE); MAIER, Martin, 71696 Moeglingen (DE); HOHL, Guenther, 70569 Stuttgart (DE)
(86) Internationale Anmeldenummer: PCT/EP2005/055012
(87) Internationale Veröffentlichungsnummer: WO 2006/063877

(56) Entgegenhaltungen:
- DE-A1- 10 317 149
- US-A1- 2003 057 394

## Beschreibung

### Stand der Technik

Die Erfindung geht aus von einer Vorrichtung mit Formgedächtniselement nach der Gattung des Hauptanspruchs.

Es ist schon eine Vorrichtung aus der JP 2001280215 A bekannt, mit einer Ventilnadel und einem Formgedächtniselement, das durch Anlegen eines regelbaren Magnetfeldes einen die Ventilnadel betätigenden Stellhub ausführt, mit einer das Magnetfeld erregenden Spule, die in einem Magnetgehäuse angeordnet ist, das stirnseitig bezüglich einer Stellachse durch jeweils eine Stirnwandung begrenzt ist, wobei beide Stirnwandungen radial innerhalb der Spule eine Durchgangsöffnung aufweisen. Der Stellhub wird durch Verkürzung des Formgedächtniselementes in Richtung einer Stellachse der Ventilnadel erreicht. Nachteilig ist, dass das um die elektrische Spule erregte Magnetfeld durch die gewählte Anordnung von metallischen Elementen und Luftspalten höchstens ein geringes Magnetfeld im Formgedächtniselement ausbildet. Das Formgedächtniselement wird, wenn überhaupt, in Richtung seiner Längserstreckung vom Magnetfeld durchströmt. Da das Formgedächtniselement einen hohen magnetischen Widerstand aufweist und in axialer Richtung sehr lang ausgebildet ist, kann nur ein sehr schwaches Magnetfeld im Formgedächtniselement induziert werden. Bei dem höchstens schwachen Magnetfeld kann das Formgedächtniselement nur einen sehr geringen Hub der Ventilnadel erzeugen. Zusätzlich ist der mechanische Spannungszustand beim Anlegen des Magnetfelds in einem zylinderförmig ausgeführten Formgedächtniselement ungünstig. Dies behindert die Hubausbildung.

Eine Vorrichtung mit einem Stellglied is ebenfalls aus DE 10317149 A bekannt. Das Stellglied der Vorrichtung ist zumindest teilweise als Formgedächtniselement ausgebildet.

### Vorteile der Erfindung

Die erfindungsgemäße Vorrichtung mit den kennzeichnenden Merkmalen des Hauptanspruchs hat demgegenüber den Vorteil, daß auf einfache Art und Weise eine Verbesserung dahingehend erzielt wird, dass ein starkes Magnetfeld durch die Formgedächtniselemente geleitet wird und auf diese Weise ein großer Stellhub erreichbar ist, indem das zumindest eine Formgedächtniselement im wesentlichen nur in zumindest einer Durchgangsöffnung angeordnet ist. Auf diese Weise werden funktionsgerechte magnetische Übergänge im Magnetkreis erzielt. Durch diese Anordnung des zumindest einen Formgedächtniselements wird erreicht, dass sich das Formgedächtniselement zum Stellglied hin ausdehnt. Das Formgedächtniselement wird außerdem derart angeordnet, dass beim Anlegen des Magnetfelds keine der Dehnungsrichtungen des Formgedächtniselements behindert wird.

Durch die in den Unteransprüchen aufgeführten Maßnahmen sind vorteilhafte Weiterbildungen und Verbesserungen der im Hauptanspruch angegebenen Vorrichtung möglich.

Besonders vorteilhaft ist, wenn in einer dem Stellglied zugewandten ersten Durchgangsöffnung zumindest ein Formgedächtniselement angeordnet ist, da das Formgedächtniselement auf diese Weise unmittelbar auf das Stellglied wirken kann.

Weiterhin vorteilhaft ist, wenn zusätzlich in einer dem Stellglied abgewandten zweiten Durchgangsöffnung zumindest ein weiteres Formgedächtniselement vorgesehen ist, das über ein nichtleitendes Verbindungsstück mit dem zugeordneten Formgedächtniselement der ersten Durchgangsöffnung verbunden ist. Auf diese Weise wird eine Reihenschaltung der Formgedächtniselemente erreicht, so dass der auf das Stellglied übertragene Hub sich aus der Addition des Stellhubs der Formgedächtniselemente aus der ersten Durchgangsöffnung mit dem Stellhub der Formgedächtniselemente aus der zweiten Durchgangsöffnung ergibt.

Sehr vorteilhaft ist es, wenn von dem Formgedächtniselement der ersten Durchgangsöffnung ausgehend zumindest ein Magnetleitstück bis in die zweite Durchgangsöffnung verläuft. Gemäss einem ersten Ausführungsbeispiel ist das Magnetleitstück über die zweite Durchgangsöffnung mit dem Magnetgehäuse verbunden. Nach einer zweiten Ausführung ist vorgesehen, in der zweiten Durchgangsöffnung ein weiteres Formgedächtniselement anzuordnen und das Magnetleitstück mit diesem zu verbinden. In beiden Ausführungen wird der Magnetkreis durch das Magnetleistück geschlossen.

Desweiteren vorteilhaft ist, wenn das Magnetleitstück in den Durchgangsöffnungen radial innerhalb der Formgedächtniselemente angeordnet ist. Da die Formgedächtniselemente von den Magnetfeldlinien aufgrund der Anordnung quer zu der Stellachse durchströmt werden, ergibt sich ein Stellhub der Formgedächtniselemente durch Ausdehnung in Richtung der Stellachse. Dies ermöglicht beispielsweise die Ausbildung eines nach aussen öffnenden Brennstoffeinspritzventils.

Darüber hinaus vorteilhaft ist, wenn das Formgedächtniselement und das Magnetleitstück in der jeweiligen Durchgangsöffnung durch ein Federelement in radialer Richtung bezüglich der Stellachse vorgespannt sind, da auf diese Weise ein besonders guter Kontakt mit geringen Luftspalten zwischen dem Magnetgehäuse, den Formgedächtniselementen und dem Magnetleitstück erreicht wird, so dass sich ein Magnetfeld mit hoher Feldstärke ausbildet.

Gemäss den vorteilhaften Ausführungen wird das zumindest eine Formgedächtniselement hülsenförmig, ringförmig, quaderförmig oder ähnlich ausgebildet.

Außerdem vorteilhaft ist, wenn in der Vorrichtung ein Koppler vorgesehen ist, der unterschiedliche Temperaturdehnungen von Bauteilen der Vorrichtung ausgleicht. Auf diese Weise ist sichergestellt, dass der Stellhub der Formgedächtniselemente nicht von Temperatureinflüssen abhängig ist.

### Zeichnung

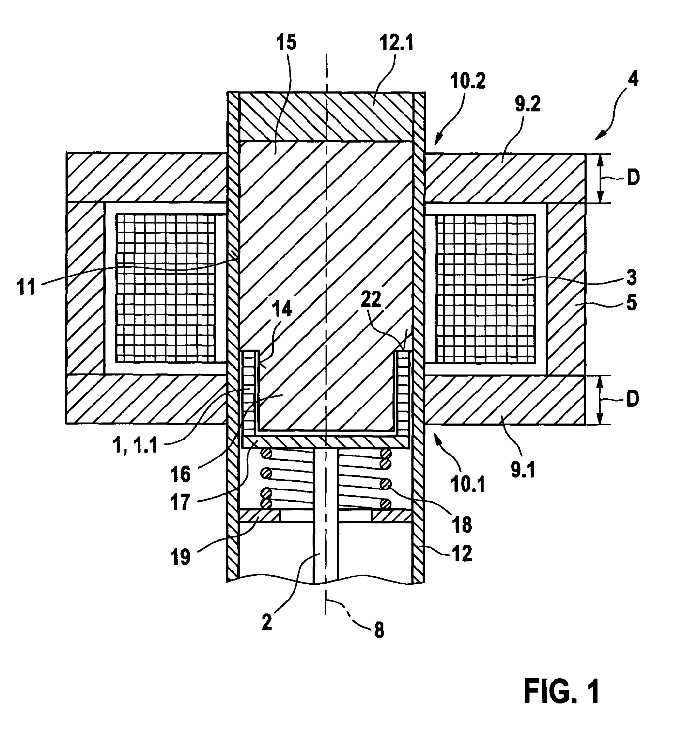

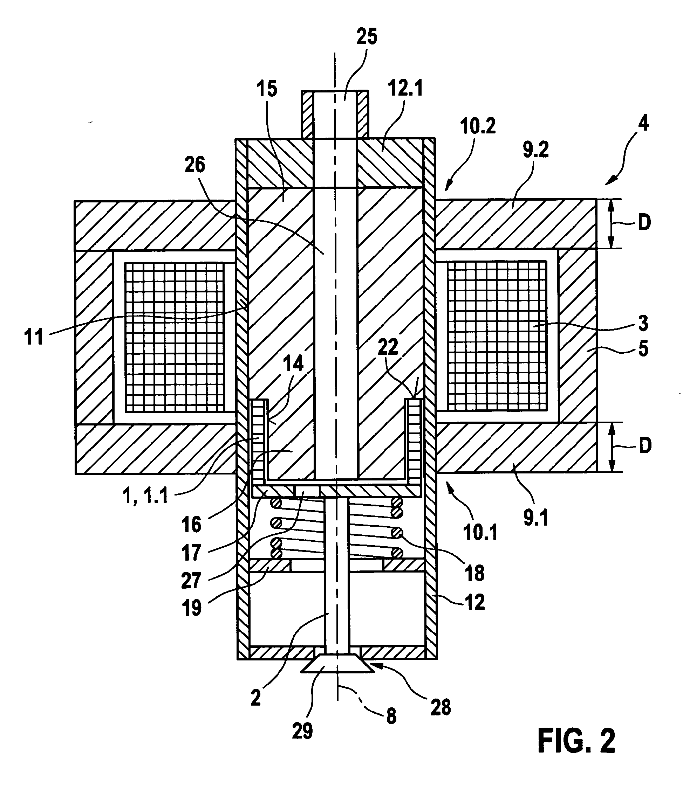

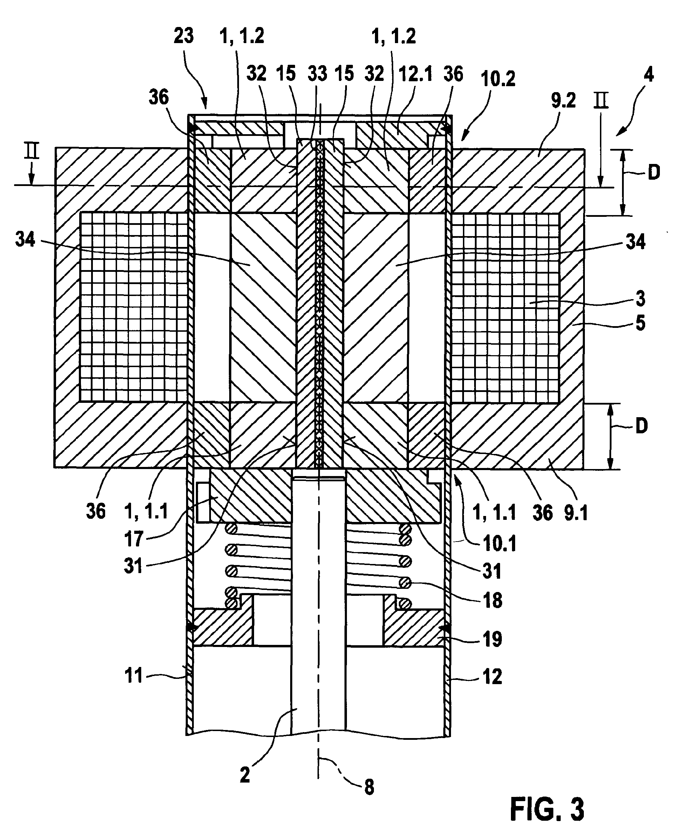

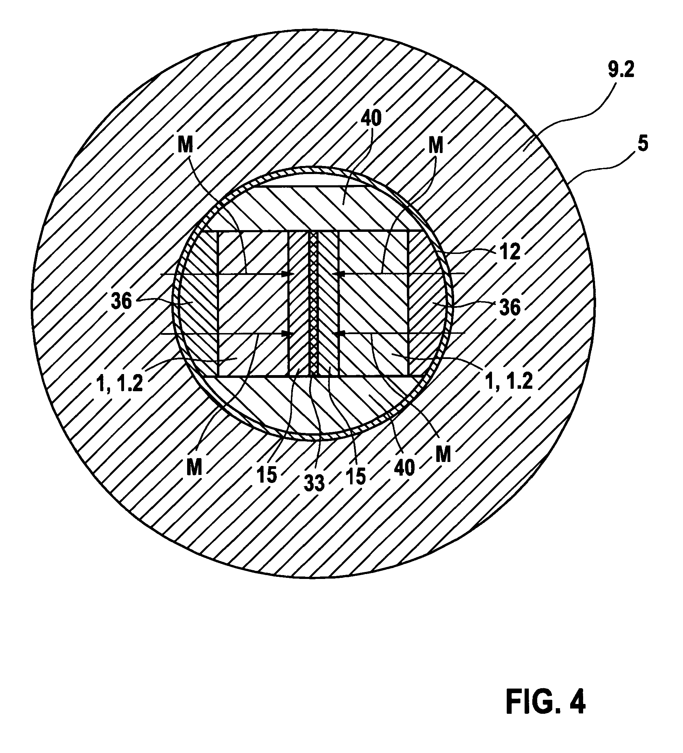

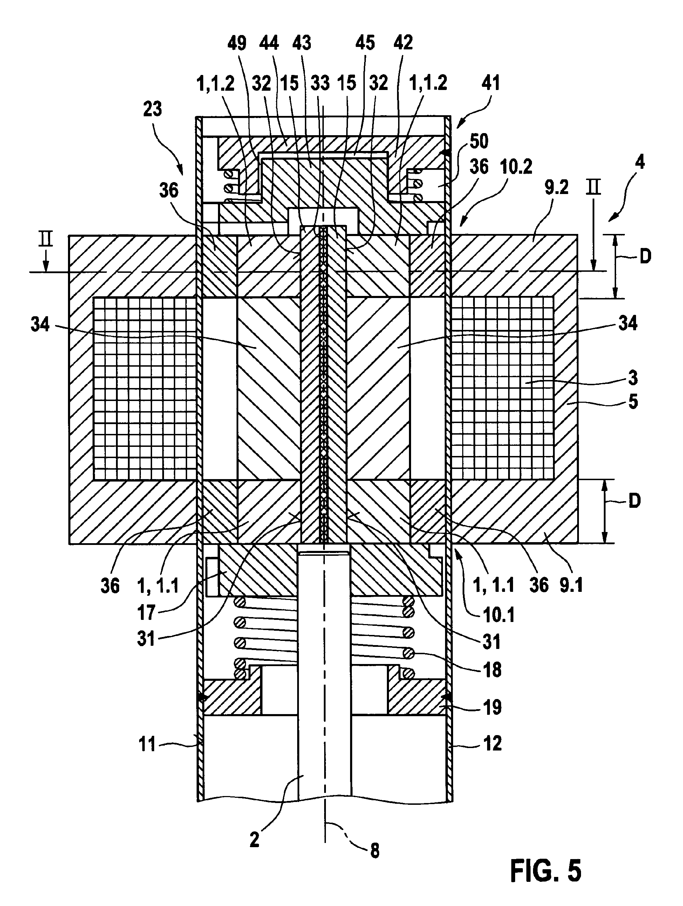

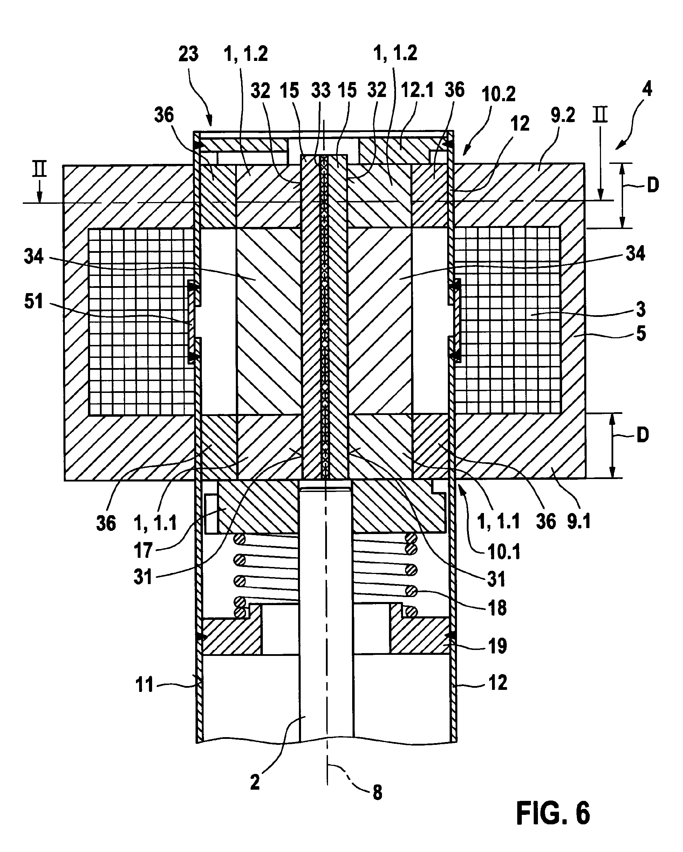

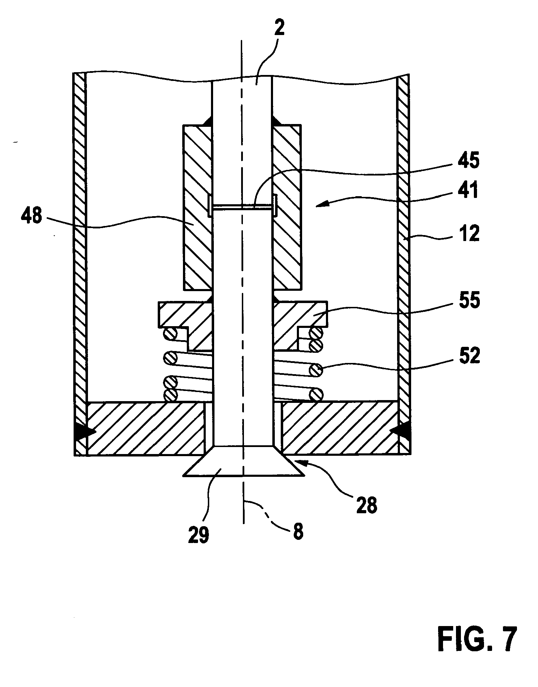

Ausführungsbeispiele der Erfindung sind in der Zeichnung vereinfacht dargestellt und in der nachfolgenden Beschreibung näher erläutert. Es zeigen Fig.1 im Schnitt ein erstes Ausführungsbeispiel der erfindungsgemäßen Vorrichtung, Fig.2 ein Brennstoffeinspritz-ventil gemäss dem erstem Ausführungsbeispiel, Fig.3 im Schnitt ein zweites Ausführungsbeispiel, Fig.4 eine Schnittansicht des zweiten Ausführungsbeispiels entlang der Linie II-II in Fig.1, Fig.5 im Schnitt ein drittes Ausführungsbeispiel, Fig.6 ein viertes Ausführungsbeispiel und Fig.7 ein fünftes Ausführungsbeispiel der erfindungsgemäßen Vorrichtung.

### Beschreibung der Ausführungsbeispiele

Fig.1 zeigt eine vereinfachte Ansicht eines ersten Ausführungsbeispiels der erfindungsgemäßen Vorrichtung mit einem Stellglied und einem Formgedächtniselement. Die Vorrichtung dient dazu, mittels eines Hubs des Formgedächtniselements das Stellglied zu betätigen. Die Vorrichtung ist z.B. ein beliebiges Ventil, beispielsweise ein Brennstoffeinspritzventil, und das Stellglied eine Ventilnadel oder ein Ventilstift.

Die erfindungsgemäße Vorrichtung weist zumindest ein Formgedächtniselement 1 auf, das als Aktor ein zugeordnetes Stellglied 2 betätigt. Das zumindest eine Formgedächtniselement 1 besteht aus einer sogenannten Formgedächtnislegierung, beispielsweise einer magnetischen Formgedächtnislegierung.

Das Formgedächtniselement 1 führt bei Anlegen eines Magnetfeldes einen das Stellglied 2 betätigenden Stellhub aus, indem es sich in Richtung der Magnetfeldlinien des Magnetfeldes zusammenzieht und sich in einer Richtung quer zu den Magnetfeldlinien ausdehnt. Eine dritte Richtung bleibt neutral. Gemäß dem ersten Ausführungsbeispiel ist das Formgedächtniselement 1 beispielsweise hülsenförmig bzw. ringförmig ausgebildet. Durch diese dünnwandige Ausführung bleibt das Zusammenziehen des zumindest einen Formgedächtniselements 1 in Richtung der Magnetfeldlinien weitgehend unbehindert.

Das Magnetfeld wird beispielsweise mit einer elektrischen Spule 3 erzeugt, die in einem Magnetgehäuse 4 angeordnet ist. Das Magnetgehäuse 4 weist beispielsweise einen zylinderförmigen Axialabschnitt 5 auf, der bezüglich einer Stellachse 8 in axialer Richtung verläuft. Der Axialabschnitt 5 des Magnetgehäuses 4 wird stirnseitig jeweils durch eine bezüglich der Stellachse 8 in radialer Richtung verlaufende Stirnwandung, einer ersten Stirnwandung 9.1 und einer zweiten Stirnwandung 9.2, begrenzt. Die ringförmig ausgebildete Spule 3 ist in dem Magnetgehäuse 4 beispielsweise konzentrisch bezüglich der Stellachse 8 angeordnet. Zumindest eine der Stirnwandungen 9.1,9.2 weist radial innerhalb der Spule 3 eine Durchgangsöffnung 10 auf. Beispielsweise hat die erste Stirnwandung 9.1 eine erste Durchgangsöffnung 10.1 und die zweite Stirnwandung 9.2 eine zweite Durchgangsöffnung 10.2. Die axiale Länge der Durchgangsöffnungen 10.1,10.2 bezüglich der Stellachse 8 ist durch die Dicke D der Stirnwandungen 9 definiert. Die Durchgangswandungen 10.1,10.2 sind in axialer Richtung bezüglich der Stellachse 8 zueinander beabstandet. Zwischen den beiden Durchgangsöffnungen 10 ist beispielsweise ein Gehäusekanal 11 vorgesehen. Der Gehäusekanal 11 ist beispielsweise durch einen Gehäuseabschnitt 12 gebildet, der durch die beiden Durchgangsöffnungen 10 verläuft und beispielsweise zylinderförmig ausgeführt ist. Das zumindest eine Fornmgedächtniselement 1 und das Stellglied 2 sind in dem Gehäuseabschnitt 12 angeordnet. Der Gehäuseabschnitt 12 ist so ausgeführt, dass kein relevanter Magnetfluss über ihn geleitet wird. Dies kann beispielsweise durch dünnwandige Gestaltung oder magnetisch nichtleitende Materialien erreicht werden.

Erfindungsgemäß ist das oder sind die Formgedächtniselemente 1 im wesentlichen nur in der oder den Durchgangsöffnungen 10.1,10.2 angeordnet. Das oder die Formgedächtniselemente 1 sind derart im Gehäuseabschnitt 12 angeordnet, dass sie sich bezüglich ihrer Längserstreckung bezüglich der Stellachse 8 im wesentlichen nur in den Durchgangsöffnungen 10 bzw. im axialen Bereich der Durchgangsöffnungen 10 befinden. Vorteilhafterweise ist das oder sind die Formgedächtniselemente 1 vollständig und ausschließlich in der oder den Durchgangsöffnungen 10.1,10.2 angeordnet.

Gemäß dem ersten Ausführungsbeispiel ist in der dem Stellglied 2 zugewandten ersten Durchgangsöffnung 10.1 ein Formgedächtniselement 1.1 angeordnet, das beispielsweise hülsenförmig oder quaderförmig ausgeführt ist. Von dem Formgedächtniselement 1.1 der ersten Durchgangsöffnung 10.1 ausgehend verläuft ein Magnetleitstück 15 bis in die zweite Durchgangsöffnung 10.2. Das Magnetleitstück 15 ist in der ersten Durchgangsöffnung 10.1 radial innerhalb des Formgedächtniselementes 1.1 bezüglich der Stellachse 8 angeordnet, indem dieses von der zweiten Durchgangsöffnung 10.2 ausgehend in axialer Richtung bis an das Formgedächtniselement 1 heranreicht und mit einem Absatz 16 in eine Ausnehmung 14 des Formgedächtniselements 1.1 hineinragt. Auf diese Weise ist eine axiale Lagerung des Formgedächtniselements 1.1 erreicht. In radialer Richtung bezüglich der Stellachse 8 gesehen ist zwischen dem Absatz 16 und dem Formgedächtniselement 1 und zwischen dem Formgedächtniselement 1 und dem Gehäuseabschnitt 12 ein möglichst geringer Spalt vorgesehen. Das Formgedächtniselement 1.1 liegt mit der einen Stirnseite an einer zweiten Schulter 22 des Absatzes 16 an und wirkt mit der anderen Stirnseite beispielsweise auf eine dritte Schulter 17 des Stellglieds 2. Das Magnetleitstück 15 ist in dem Gehäuseabschnitt 12 unbeweglich vorgesehen und beispielsweise fest mit dem Gehäuseabschnitt 12 verbunden. Der Gehäuseabschnitt 12 ist beispielsweise auf der dem Stellglied 2 abgewandten Stirnseite durch einen Gehäusedeckel 12.1 verschlossen. Das Magnetleitstück 15 liegt mit seiner dem Formgedächtniselement 1.1 abgewandten Stirnseite beispielsweise an dem Gehäusedeckel 12.1 1 an. Wenn sich das Formgedächtniselement 1 quer zu den Magnetfeldlinien ausdehnt, stützt sich das Formgedächtniselement 1.1 an der zweiten Schulter 22 des Absatzes 16 ab und überträgt den Stellhub in einer von der zweiten Schulter 22 abgewandten Richtung auf das Stellglied 2.

In dem Gehäuseabschnitt 12 ist eine Rückstellfeder 18 angeordnet, die sich mit ihrem einen Ende an einer Halterung 19 des Gehäuseabschnitts 12 abstützt und mit ihrem anderen Ende beispielsweise über die dritte Schulter 17 rückstellend auf das Stellglied 2 wirkt. Da die dritte Schulter 17 des Stellglieds 2 an dem Formgedächtniselement 1.1 anliegt, drückt die Rückstellfeder 18 das Formgedächtniselement 1.1 gegen die zweite Schulter 22 des Absatzes 16.

Beim Einschalten der elektrischen Spule 3 wird ein Magnetfeld erzeugt, dessen Magnetfeldlinien über den Axialabschnitt 5, die erste Stirnwandung 9.1, eine Wandung des Gehäusekanals 11 in der ersten Durchgangsöffnung 10.1, das Formgedächtniselement 1.1, das Magnetleitstück 15, eine Wandung des Gehäusekanals 11 in der zweiten Durchgangsöffnung 10.2 und die zweite Stirnwandung 9.2 verlaufen. Das Formgedächtniselement 1 zieht sich dabei in Richtung der Magnetfeldlinien zusammen und dehnt sich quer dazu in Richtung der Stellachse 8 aus.

Fig.2 zeigt ein Brennstoffeinspritzventil gemäss dem erstem Ausführungsbeispiel der erfindungsgemäßen Vorrichtung.

Bei der Vorrichtung nach Fig.2 sind die gegenüber der Vorrichtung nach Fig.1 gleichbleibenden oder gleichwirkenden Teile durch die gleichen Bezugszeichen gekennzeichnet.

Das Brennstoffeinspritzventil hat einen Einlass 25 für Kraftstoff. Das Stellglied 2 ist als Ventilnadel ausgebildet und weist einen mit einem Ventilsitz 28 zusammenwirkenden Schliesskörper 29 auf. Das Brennstoffeinspritzventil ist beispielsweise als nach außen öffnendes Ventil ausgebildet, das stromlos geschlossen ist, und öffnet mit der Ventilnadel 2 in vom Formgedächtniselement 1 abgewandter Richtung. Das Brennstoffeinspritzventil kann aber auch als nach innen öffnendes Ventil ausgeführt werden, das stromlos geöffnet ist. Stromab des Einlasses 25 gelangt der Kraftstoff über eine im Magnetleitstück 15 vorgesehene Kraftstoffleitung 26 und eine in der dritten Schulter 17 angeordnete Verbindungsöffnung 27 in den Gehäuseabschnitt 12 und bis an den Ventilsitz 28. Bei geöffnetem Brennstoffeinspritzventil wird der Kraftstoff aus dem Gehäuseabschnitt 12 über einen Öffnungsspalt zwischen dem Ventilsitz 28 und dem Schliesskörper 29 in einen Brennraum einer Brennkraftmaschine eingespritzt.

Fig.3 zeigt im Schnitt eine vereinfachte Ansicht eines zweiten Ausführungsbeispiels der erfindungsgemäßen Vorrichtung.

Bei der Vorrichtung nach Fig.3 sind die gegenüber der Vorrichtung nach Fig.1 und Fig.2 gleichbleibenden oder gleichwirkenden Teile durch die gleichen Bezugszeichen gekennzeichnet.

Die Vorrichtung nach Fig.3 unterscheidet sich von der Vorrichtung nach Fig.1 und Fig.2 darin, dass nicht nur in der ersten Durchgangsöffnung 10.1, sondern in beiden Durchgangsöffnungen 10.1,10.2 zumindest ein Formgedächtniselement 1.2 angeordnet ist.

Gemäss dem zweiten Ausführungsbeispiel ist in der dem Stellglied 2 abgewandten zweiten Durchgangsöffnung 10.2 zusätzlich zumindest ein weiteres Formgedächtniselement 1.2 vorgesehen, das über ein magnetisch nichtleitendes Verbindungsstück 34 mit dem zugeordneten Formgedächtniselement 1.1 der ersten Durchgangsöffnung 10.1 verbunden ist. Die Verbindungsmittel 34 verlaufen in Richtung der Stellachse 8. Durch die übereinander angeordneten und jeweils durch ein Verbindungsmittel 34 gekoppelten Formgedächtniselemente 1 wird eine Reihenschaltung der Formgedächtniselemente 1 erreicht, so dass der auf das Stellglied 2 übertragene Hub sich aus der Addition des Stellhubs der Formgedächtniselemente 1.1 aus der ersten Durchgangsöffnung 10.1 mit dem Stellhub der Formgedächtniselemente 1.2 aus der zweiten Durchgangsöffnung 10.2 ergibt. Die Formgedächtniselemente 1.1,1.2 einer Durchgangsöffnung 10.1,10.2 sind parallel geschaltet, so dass sich nicht deren Stellhübe, sondern deren Stellkräfte addieren.

Beispielsweise sind in jeder Durchgangsöffnung 10.1,10.2 jeweils zwei Formgedächtniselemente 1.1,1.2 vorgesehen. Diese sind beispielsweise vollständig und ausschließlich in den Durchgangsöffnungen 10.1,10.2 vorgesehen. Außerdem sind zwei Verbindungsstücke 34 und zwei Magnetleitstücke 15 in dem Gehäuseabschnitt 12 angeordnet, die jeweils ein Formgedächtniselement 1.1 der ersten Durchgangsöffnung 10.1 mit einem Formgedächtniselement 1.2 der zweiten Durchgangsöffnung 10.2 verbinden. Zwischen den Formgedächtniselementen 1.1,1.2 einer Durchgangsöffnung 10.1,10.2 sind die Magnetleitstücke 15 angeordnet. Zwischen dem Gehäuseabschnitt 12 und den Formgedächtniselementen 1 ist im Bereich der Durchgangsöffnungen 10.1,10.2 jeweils ein Zwischenstück 36 angeordnet, um die quaderförmigen Formgedächtniselemente 1 mit dem zylinderförmigen Gehäuseabschnitt 12 und dem Magnetgehäuse 4 zu kontaktieren. Beispielsweise sind in jeder Durchgangsöffnung 10.1,10.2 zwei Zwischenstücke 36 angeordnet. Die Zwischenstücke 36 sind magnetisch leitend und beispielsweise kreissegmentförmig ausgeführt. Sie können auch einstückig am Gehäusekanal 11 ausgebildet sein. Gemäss der beschriebenen Anordnung ergibt sich ein Stapel mit drei Schichten, von denen die äußeren Schichten durch die jeweils zwei Formgedächtniselemente 1 und die zwei Zwischenstücke 36 gebildet sind und die mittlere Schicht die zwei Verbindungsmittel 34 aufweist. Die beiden äußeren Schichten sind durch die Magnetleitstücke 15 miteinander verbunden. Die dreischichtige Anordnung wird im folgenden als Aktorpaket 23 bezeichnet.

Die Magnetleitstücke 15 verlaufen jeweils von einer ersten Innenseite 31 des Formgedächtniselementes 1.1 der ersten Durchgangsöffnung 1.1 bis an eine zweite Innenseite 32 des weiteren Formgedächtniselementes 1.2 der zweiten Durchgangsöffnung 10.2. Die zwei Magnetleitstücke 15 können auch als ein einziges Magnetleitstück 15 ausgeführt sein.

Die Verbindungsstücke 34 verbinden jeweils die einander zugewandten Seiten eines Formgedächtniselements 1.1 der ersten Durchgangsöffnung 10.1 und eines Formgedächtniselements 1.2 der zweiten Durchgangsöffnung 10.2.

Die Formgedächtniselemente 1.1,1.2 sind beispielsweise quaderförmig, würfelförmig oder ähnlich und die Magnetleitstücke 15 beispielsweise plattenförmig ausgebildet.

Die Formgedächtniselemente 1 und die Magnetleitstücke 15 sind in der jeweiligen Durchgangsöffnung 10.1,10.2 beispielsweise durch ein Federelement 33 in radialer Richtung bezüglich der Stellachse 8 vorgespannt. Auf diese Weise wird ein besonders guter Kontakt ohne Luftspalt zwischen dem Magnetgehäuse 4, den Formgedächtnis-elementen 1 und dem Magnetleitstück 15 erreicht, so dass sich ein Magnetfeld mit hoher Feldstärke ausbildet. Bei dem zweiten Ausführungsbeispiel ist zwischen den Magnetleitstücken 15 eine vorgespannte elastische Zwischenschicht als Federelement 33 vorgesehen, die die Formgedächtniselemente 1 nach radial aussen bezüglich der Stellachse 8 gegen den Gehäuseabschnitt 12 drücken.

Die Formgedächtniselemente 1 der zweiten Durchgangsöffnung 10.2 liegen mit ihrer dem Stellglied 2 abgewandten Oberseite beispielsweise an dem Gehäusedeckel 12.1 an, der fest mit dem Gehäuseabschnitt 12 verbunden ist. In der von dem Gehäusedeckel 12.1 abgewandten Richtung sind die Formgedächtniselemente 1 und die Verbindungssmittel 34 axial beweglich angeordnet, um den Hub der Formgedächtniselemente 1 auf das Stellglied 2 zu übertragen. Die dritte Schulter 17 des Stellglieds 2 liegt an den Formgedächtniselementen 1,1 der ersten Durchgangsöffnung 10.1. Die Rückstellfeder 18 stützt sich mit ihrem einen Ende an der Halterung 19 des Gehäuseabschnitts 12 ab, wirkt mit dem anderen Ende auf die dritte Schulter 17 des Stellglieds 2 und drückt die Formgedächtniselemente 1 der Durchgangsöffnungen 10.1,10.2 mit den Verbindungsmitteln 34 in Richtung des Gehäusedeckels 12.1.

Beim Einschalten der elektrischen Spule 3 wird ein Magnetfeld erzeugt, dessen Magnetfeldlinien über den Axialabschnitt 5, die erste Stirnwandung 9.1, eine Wandung des Gehäuseabschnitts 12 in der ersten Durchgangsöffnung 10.1, eines der Zwischenstücke 36 der ersten Durchgangsöffnung 10.1, das Formgedächtniselement 1.1 der ersten Durchgangsöffnung 10.1, das Magnetleitstück 15, das Formgedächtniselement 1.2 in der zweiten Durchgangsöffnung 10.2, eines der Zwischenstücke 36 der zweiten Durchgangsöffnung 10.2, eine Wandung des Gehäusekanals 11 in der zweiten Durchgangsöffnung 10.2 und die zweite Stirnwandung 9.2 verlaufen. Das Formgedächtniselement 1 zieht sich dabei in Richtung der Magnetfeldlinien zusammen und dehnt sich quer dazu in Richtung der Stellachse 8 aus.

Die Vorrichtung gemäss dem zweiten Ausführungsbeispiel kann auch als ein Brennstoffeinspritzventil mit einer Ventilnadel 2 als Stellglied ausgebildet sein.

Fig.4 zeigt eine Schnittansicht des zweiten Ausführungsbeispiels entlang der Linie II-II in Fig.1.

Bei der Vorrichtung nach Fig.4 sind die gegenüber der Vorrichtung nach Fig.1 bis Fig.3 gleichbleibenden oder gleichwirkenden Teile durch die gleichen Bezugszeichen gekennzeichnet.

In dem beispielsweise kreisförmigen Gehäuseabschnitt 12 sind die quaderförmigen Formgedächtniselemente 1 mit den plattenförmigen Magnetleitstücken 15 und der elastischen Zwischenschicht 33 mittig bezüglich der Stellachse 8 angeordnet. Die kreissegmentförmigen Zwischenstücke 36 schliessen den Magnetkreis zwischen den Formgedächtniselementen 1 und dem Gehäuseabschnitt 12, indem diese an einer Seite der Formgedächtniselemente 1 und an der Wandung des Gehäuseabschnitts 12 anliegen. Die Magnetfeldlinien verlaufen in dem Querschnitt entsprechend den eingezeichneten Pfeilen M.

In dem zylinderförmigen Gehäuseabschnitt 12 sind außerdem magnetisch nicht leitende Abstandsstücke 40 zur Lagefixierung der Formgedächtniselemente 1, der Magnetleitstücke 15 und der Zwischenstücke 36 vorgesehen.

Fig.5 zeigt eine vereinfachte Ansicht eines dritten Ausführungsbeispiels.

Bei der Vorrichtung nach Fig.5 sind die gegenüber der Vorrichtung nach Fig.1 bis Fig.4 gleichbleibenden oder gleichwirkenden Teile durch die gleichen Bezugszeichen gekennzeichnet.

Die Vorrichtung nach Fig.5 unterscheidet sich von der Vorrichtung nach Fig.3 darin, dass ein Koppler 41 vorgesehen ist, der unterschiedliche Temperaturdehnungen in der Vorrichtung ausgleicht.

Der Koppler 41 ist beispielsweise als ein hydraulischer Koppler ausgeführt. Der Koppler 41 weist beispielsweise einen topfförmigen Zylinder 42 und einen in dem Zylinder 42 axial beweglichen Kolben 43 auf. Zwischen einem Topfboden 44 des Zylinders 42 ist ein mit Flüssigkeit gefüllter Kopplerspalt 45 vorgesehen. Der Koppler 41 ist beispielsweise auf der dem Stellglied 2 abgewandten Seite des Aktorpakets 23 angeordnet. Das Aktorpaket 23 stützt sich an dem Kolben 43 ab. Bei zeitlich schnellen auf den hydraulischen Koppler 41 wirkenden Bewegungsvorgängen, wie beispielsweise der Ausdehnung der Formgedächtniselemente 1 bei Anlegen eines regelbaren Magnetfeldes, verhält sich der hydraulische Koppler 41 als extrem steifes Bauteil, da in der kurzen Zeit fast keine Flüssigkeit aus dem Kopplerspalt 45 entweichen kann. Da also der Kopplerspalt 45 konstant bleibt, wird der Stellhub der Formgedächtniselemente 1 vollständig auf das Stellglied 2 übertragen. Bei zeitlich langsamen auf den hydraulischen Koppler 41 wirkenden Bewegungsvorgängen, wie beispielsweise der Dehnung aufgrund von Temperaturänderungen, verkleinert oder vergrößert sich der Kopplerspalt 45, da die Flüssigkeit genügend Zeit hat, aus dem Kopplerspalt 45 heraus- oder in den Kopplerspalt 45 hineinzuströmen.

Der Kopplerspalt 45 ist über einen Leckagespalt 49 oder eine Drossel mit einer mit Flüssigkeit gefüllten Ausgleichskammer 50 strömungsverbunden. Er kann mit Kraftstoff oder mit einer separaten Flüssigkeit gefüllt sein.

Fig.6 zeigt eine vereinfachte Ansicht eines vierten Ausführungsbeispiels.

Bei der Vorrichtung nach Fig.6 sind die gegenüber der Vorrichtung nach Fig.1 bis Fig.5 gleichbleibenden oder gleichwirkenden Teile durch die gleichen Bezugszeichen gekennzeichnet.

Die Vorrichtung nach Fig.6 unterscheidet sich von der Vorrichtung nach Fig.5 darin, dass kein Koppler 41 vorgesehen ist, sondern unterschiedliche Temperaturdehnungen in der Vorrichtung durch eine gezielte Auswahl des Wärmedehnungskoeffizienten eines am Gehäuseabschnitt 12 vorgesehenen Ausgleichselements 51 vermieden werden.

Bei dem vierten Ausführungsbeispiel ist der Gehäuseabschnitt 12 in zwei Abschnitte getrennt, die über das Ausgleichselement 51 fest miteinander verbunden sind. Da die Wärmeausdehnungskoeffizienten von dem Gehäuseabschnitt 12 und den Formgedächtniselementen 1 unterschiedlich sind, wird der Wärmeausdehnungskoeffizient des Ausgleichselements 51 derart ausgewählt, dass sich keine oder nur eine geringe Wärmedehnungsdifferenz zwischen dem Gehäuseabschnitt 12 und den Formgedächtniselementen 1 ergibt.

Fig.7 zeigt eine vereinfachte Ansicht eines fünften Ausführungsbeispiels.

Bei der Vorrichtung nach Fig.7 sind die gegenüber der Vorrichtung nach Fig.1 bis Fig.6 gleichbleibenden oder gleichwirkenden Teile durch die gleichen Bezugszeichen gekennzeichnet.

Die Vorrichtung nach Fig.7 unterscheidet sich von der Vorrichtung nach Fig.5 darin, dass der Koppler 41 nicht an der dem Stellglied 2 abgewandten Seite des Aktorpakets 23 angeordnet, sondern am Stellglied 2 vorgesehen ist. Die Ventilnadel 2 und der Schliesskörper 28 sind zweiteilig und voneinander getrennt ausgebildet. Der Koppler 41 ist gebildet durch eine Zylinderhülse 48, in die die Ventilnadel 2 und der Schliesskörper 29 hineinragen. Die Zylinderhülse 48 und die Stirnseiten der Ventilnadel 2 und des Schliesskörpers 29 begrenzen auf diese Weise den flüssigkeitsgefüllten Kopplerspalt 45. Der Schliesskörper 29 wird von einer Feder 52 in Richtung des Ventilsitzes 28 gedrückt. Die Feder 52 ist an ihrem einen Ende am Gehäuseabschnitt 12 abgestützt und wirkt mit dem anderen Ende über eine vierte Schulter 55 auf den Schliesskörper 29.

## Patentansprüche

1. Vorrichtung mit einem Stellglied und zumindest einem Formgedächtniselement, das durch Anlegen eines regelbaren Magnetfeldes einen das Stellglied betätigenden Stellhub ausführt, mit einer das Magnetfeld erregenden Spule (3), die in einem Magnetgehäuse (4) angeordnet ist, das stirnseitig bezüglich einer Stellachse durch jeweils eine Stirnwandung (9.1, 9.2) begrenzt ist, wobei zumindest eine der Stirnwandungen radial innerhalb der Spule eine Durchgangsöffnung (10) aufweist, **dadurch gekennzeichnet, dass** das zumindest eine Formgedächtniselement (1,1.1,1.2) im wesentlichen nur in der zumindest einen der Durchgangsöffnungen (10.1,10.2) angeordnet ist.

2. Vorrichtung nach Anspruch 1, **dadurch gekennzeichnet, dass** in einer dem Stellglied (2) zugewandten ersten Durchgangsöffnung (10.1) des Magnetgehäuses (4) zumindest ein Formgedächtniselement (1.1) angeordnet ist.

3. Vorrichtung nach Anspruch 2, **dadurch gekennzeichnet, dass** zusätzlich in einer dem Stellglied abgewandten zweiten Durchgangsöffnung (10.2) des Magnetgehäuses (4) zumindest ein weiteres Formgedächtniselement (1.2) vorgesehen ist, das über ein nichtleitendes Verbindungsstück (34) mit dem Formgedächtniselement (1) in der ersten Durchgangsöffnung (10.1) verbunden ist.

4. Vorrichtung nach Anspruch 2, **dadurch gekennzeichnet, dass** von dem Formgedächtniselement (1.1) der ersten Durchgangsöffnung (10.1) ausgehend zumindest ein Magnetleitstück (15) bis in die zweite Durchgangsöffnung (10.2) verläuft.

5. Vorrichtung nach Anspruch 4, **dadurch gekennzeichnet, dass** das Magnetleitstück (15) über die zweite Durchgangsöffnung (10.2) mit dem Magnetgehäuse (4) verbunden ist.

6. Vorrichtung nach Anspruch 4, **dadurch gekennzeichnet, dass** das Magnetleitstück (15) mit einem Formgedächtniselement (1.2) der zweiten Durchgangsöffnung (10.2) verbunden ist.

7. Vorrichtung nach Anspruch 4, **dadurch gekennzeichnet, dass** das Magnetleitstück (15) in den Durchgangsöffnungen (10.1,10.2) radial innerhalb der Formgedächtniselemente (1,1.1,1.2) bezüglich der Stellachse (8) angeordnet ist.

8. Vorrichtung nach Anspruch 4, **dadurch gekennzeichnet, dass** das Formgedächtniselement (1,1.1,1.2) und das Magnetleitstück (15) in der jeweiligen Durchgangsöffnung (10.1,10.2) durch ein Federelement (33) in radialer Richtung bezüglich der Stellachse (8) vorgespannt sind.

9. Vorrichtung nach Anspruch 1, **dadurch gekennzeichnet, dass** das zumindest eine Formgedächtniselement (1,1.1,1.2) hülsenförmig, ringförmig oder quaderförmig ausgebildet ist.

10. Vorrichtung nach Anspruch 1, **dadurch gekennzeichnet, dass** ein Koppler (41) vorgesehen ist, der unterschiedliche Temperaturdehnungen in der Vorrichtung ausgleicht.

## Claims

1. Device comprising a final control element and at least one shape memory element which, by the application of a regulatable magnetic field, performs an adjusting movement that activates the final control element, comprising a coil (3) which excites the magnetic field and is arranged in a magnet housing (4) that is delimited, at the end in relation to an adjusting axis, by a respective end wall (9.1, 9.2), wherein at least one of the end walls has a through-opening (10) radially within the coil, **characterized in that** the at least one shape memory element (1, 1.1, 1.2) is substantially arranged only in the at least one of the through-openings (10.1, 10.2).

2. Device according to Claim 1, **characterized in that** at least one shape memory element (1.1) is arranged in a first through-opening (10.1), which faces towards the final control element (2), in the magnet housing (4).

3. Device according to Claim 2, **characterized in that** at least one further shape memory element (1.2) is additionally provided in a second through-opening (10.2), which faces away from the final control element, in the magnet housing (4) and is connected, via a non-conductive connection piece (34), to the shape memory element (1) in the first through-opening (10.1).

4. Device according to Claim 2, **characterized in that**, proceeding from the shape memory element (1.1) in the first through-opening (10.1), at least one magnetic conductive element (15) extends as far as into the second through-opening (10.2).

5. Device according to Claim 4, **characterized in that** the magnetic conductive element (15) is connected to the magnet housing (4) via the second through-opening (10.2).

6. Device according to Claim 4, **characterized in that** the magnetic conductive element (15) is connected to a shape memory element (1.2) in the second through-opening (10.2).

7. Device according to Claim 4, **characterized in that** the magnetic conductive element (15) is arranged in the through-openings (10.1, 10.2) radially within the shape memory elements (1, 1.1, 1.2) in relation to the adjusting axis (8).

8. Device according to Claim 4, **characterized in that** the shape memory element (1, 1.1, 1.2) and the magnetic conductive element (15) in the respective through-opening (10.1, 10.2) are prestressed by a spring element (33) in the radial direction in relation to the adjusting axis (8).

9. Device according to Claim 1, **characterized in that** the at least one shape memory element (1, 1.1, 1.2) has a sleeve-shaped, annular or cuboidal design.

10. Device according to Claim 1, **characterized in that** a coupler (41), which compensates for different thermal expansions in the device, is provided.

## Revendications

1. Dispositif comprenant un actionneur et au moins un élément à mémoire de forme, qui effectue une course de réglage actionnant l'actionneur en appliquant un champ magnétique réglable, avec une bobine (3) excitant le champ magnétique, qui est disposée dans un boîtier magnétique (4) qui est limité du côté frontal par rapport à un axe de réglage par une paroi frontale respective (9.1, 9.2), au moins l'une des parois frontales présentant radialement à l'intérieur de la bobine une ouverture de passage (10), **caractérisé en ce que** l'au moins un élément à mémoire de forme (1, 1.1, 1.2) est disposé essentiellement uniquement dans l'au moins une des ouvertures de passage (10.1, 10.2).

2. Dispositif selon la revendication 1, **caractérisé en ce que** dans une première ouverture de passage (10.1) du boîtier magnétique (4), tournée vers l'actionneur (2), est disposé au moins un élément à mémoire de forme (1.1).

3. Dispositif selon la revendication 2, **caractérisé en ce qu'**en outre dans une deuxième ouverture de passage (10.2) du boîtier magnétique (4), opposée à l'actionneur, est prévu au moins un autre élément à mémoire de forme (1.2), qui est connecté par le biais d'un élément de connexion non conducteur (34) à l'élément à mémoire de forme (1) dans la première ouverture de passage (10.1).

4. Dispositif selon la revendication 2, **caractérisé en ce que** partant de l'élément à mémoire de forme (1.1) de la première ouverture de passage (10.1), au moins une pièce conductrice magnétique (15) s'étend jusque dans la deuxième ouverture de passage (10.2).

5. Dispositif selon la revendication 4, **caractérisé en ce que** la pièce conductrice magnétique (15) est connectée par le biais de la deuxième ouverture de passage (10.2) au boîtier magnétique (4).

6. Dispositif selon la revendication 4, **caractérisé en ce que** la pièce conductrice magnétique (15) est connectée à un élément à mémoire de forme (1.2) de la deuxième ouverture de passage (10.2).

7. Dispositif selon la revendication 4, **caractérisé en ce que** la pièce conductrice magnétique (15) est disposée dans les ouvertures de passage (10.1, 10.2) radialement à l'intérieur des éléments à mémoire de forme (1, 1.1, 1.2) par rapport à l'axe de réglage (8).

8. Dispositif selon la revendication 4, **caractérisé en ce que** l'élément à mémoire de forme (1, 1.1, 1.2) et la pièce conductrice magnétique (15) dans l'ouverture de passage respective (10.1, 10.2) sont précontraints par un élément à ressort (33) dans la direction radiale par rapport à l'axe de réglage (8).

9. Dispositif selon la revendication 1, **caractérisé en ce que** l'au moins un élément à mémoire de forme (1, 1.1, 1.2) est réalisé en forme de douille, en forme de bague ou en forme parallélépipédique.

10. Dispositif selon la revendication 1, **caractérisé en ce qu'**un coupleur (41) est prévu, lequel compense les dilatations thermiques différentes dans le dispositif.
